# EUROPEAN PATENT SPECIFICATION

(11) **EP 3 772 116 B1**
(45) Date of publication and mention of the grant of the patent: **28.01.2026**
(21) Application number: 20188627.2
(22) Date of filing: 30.07.2020
(51) Int. Cl.: H10N 30/853, H10N 30/076

(54) **PIEZOELECTRIC ELEMENT AND MANUFACTURING METHOD THEREOF**
PIEZOELEKTRISCHES BAUELEMENT UND HERSTELLUNGSVERFAHREN DAFÜR
COMPOSANT PIÉZOÉLECTRIQUE ET SON PROCÉDÉ DE FABRICATION

(30) Priority: 02.08.2019 JP 2019143328
(43) Date of publication of application: 03.02.2021
(73) Proprietor: SUMITOMO CHEMICAL COMPANY LIMITED, Chuo-ku Tokyo 104-8260 (JP)
(72) Inventor: SHIBATA, Kenji, Hitachi-shi, Ibaraki 3191418 (JP); WATANABE, Kazutoshi, Hitachi-shi, Ibaraki 3191418 (JP); KURODA, Toshiaki, Hitachi-shi, Ibaraki 3191418 (JP)
(74) Representative: Vossius & Partner Patentanwälte Rechtsanwälte mbB

(56) References cited:
- EP-A1- 3 364 471
- WO-A1-2016/143475
- JP-A- 2009 242 161
- US-A1- 2009 236 944
- US-A1- 2014 339 961

## Description

### TECHNICAL FIELD

The present disclosure relates to a piezoelectric stack and a piezoelectric element.

### BACKGROUND

A piezoelectric material is utilized widely for a functional electronic component such as a sensor and an actuator. Lead-based materials, in particular, PZT-based ferroelectrics represented by a composition formula of Pb(Zr₁₋ₓTiₓ)O₃ are used widely for the piezoelectric material. Since PZT-based piezoelectric material contains lead, it is not preferable from a viewpoint of a pollution prevention and the like. Therefore, potassium sodium niobium oxide (KNN) is suggested as a piezoelectric material not containing lead (see patent documents 1 and 2, for example). Recently, it is strongly required to further improve a performance of the piezoelectric material composed of the material not containing lead such as KNN.
Patent document 3 relates to a method for manufacturing a piezoelectric thin film element 1, which comprises: a step for forming a piezoelectric thin film 3 that contains potassium-sodium niobate on a substrate 2 by sputtering; and a step for forming first and second electrodes 4, 5 that are in contact with the piezoelectric thin film 3. In the step for forming the piezoelectric thin film 3, the piezoelectric thin film 3 is formed by sequentially forming a first piezoelectric thin film part 3a and a second piezoelectric thin film part 3b, which is thicker than the first piezoelectric thin film part 3a, in this order with use of a same target.
Patent document 4 concerns a thin film piezoelectric element comprising a potassium sodium niobate thin film having a structure in which a plurality of crystal grains are present in a film thickness direction; and a pair of electrode films sandwiching the potassium sodium niobate thin film, wherein when the potassium sodium niobate thin film is divided into three regions of the same thickness in the film thickness direction and average crystal grain sizes A1, A2, and A3 of the respective regions are determined, a ratio m/M of the smallest average crystal grain size m among A1, A2, and A3 to the largest average crystal grain size M among A1, A2, and A3 is 10% to 80% and the region having the smallest average crystal grain size m lies next to one of the pair of electrode films.
Patent document 5 discloses a laminated substrate with a piezoelectric thin film, comprising a substrate; an electrode film formed on the substrate; and a piezoelectric thin film formed on the electrode film, wherein the piezoelectric thin film is made of an alkali niobium oxide represented by a composition formula of (K₁₋ₓNaₓ)NbO₃ (0 < x < 1), having a perovskite structure, oriented preferentially in (001) plane direction, and containing a metallic element selected from a group consisting of Mn and Cu at a concentration of 0.2 at% or more and 0.6 at% or less. Patent document 6 relates to a ceramic powder for aerosol deposition which consists primarily of a compound not containing lead as a constituent element, wherein the ceramic powder has an average particle size of 0.6-1.7 µm and a lattice strain of ≤0.3.

Patent document 1: Japanese Patent Laid Open Publication No. 2007-184513 & US 2007/126313 A1
Patent document 2: Japanese Patent Laid Open Publication No. 2008-159807 & US 2009/236944 A1
Patent document 3: WO 2016/143475 A1
Patent document 4: US 2014/339961 A1
Patent document 5: EP 3 364 471 A1
Patent document 6: JP 2009 242161 A

### SUMMARY

An object of the present invention is to improve an etching efficiency of a piezoelectric film comprised of alkali niobium oxide.

According to the present invention, there is provided a piezoelectric stack according to independent claim 1.

The piezoelectric stack of the present invention comprises a piezoelectric film comprised of alkali niobium oxide and having a high etching efficiency.

### BRIEF DESCRIPTION OF THE DRAWINGS

FIG. 1 is a view illustrating an example of a cross-section structure of a piezoelectric stack according to an embodiment of the present invention.
FIG. 2 is a view illustrating a modified example of the cross-section structure of the piezoelectric stack according to an embodiment of the present invention.
FIG. 3 is a view illustrating an example of a schematic constitution of a piezoelectric device according to an embodiment of the present invention.
FIG. 4 is a view illustrating an example of the cross-section structure of the piezoelectric stack according to another embodiment of the present invention.
FIG. 5 is a view illustrating the schematic constitution of the piezoelectric device according to another embodiment of the present invention.

### EMBODIMENTS

### <An embodiment of the present invention>

An embodiment of the present invention will be described hereafter, with reference to drawings.

### (1) A constitution of a piezoelectric stack

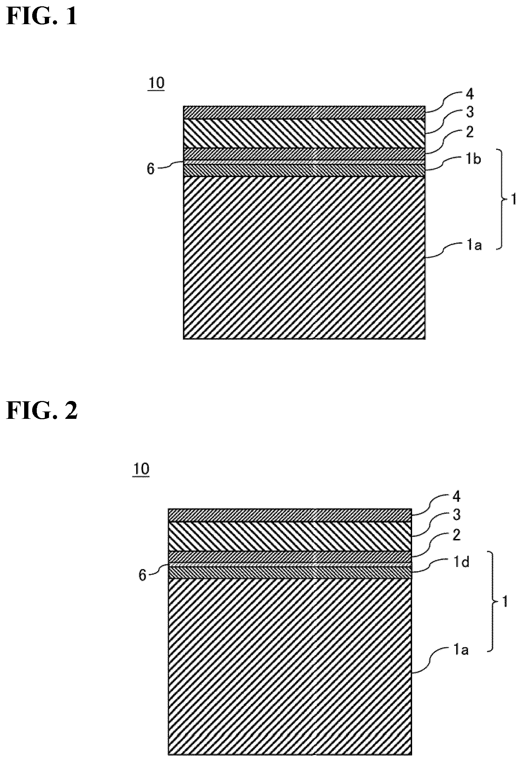

As illustrated in FIG. 1, a stack (stacked substrate) 10 (also referred to as piezoelectric stack 10 hereafter) having a piezoelectric film according to the present embodiment includes a substrate 1, a bottom electrode film 2 formed on the substrate 1, a piezoelectric film (piezoelectric thin film) 3 formed on the bottom electrode film 2, and a top electrode film 4 formed on the piezoelectric film 3.

As the substrate 1, a single-crystal silicon (Si) substrate 1a on which a surface oxide film (SiO₂-film) 1b such as a thermal oxide film or a CVD (Chemical Vapor Deposition) oxide film is formed (provided), namely, a Si-substrate including the surface oxide film, can be used preferably. Further, as illustrated in FIG. 2, a Si-substrate 1a including an insulating film 1d formed on its surface may also be used as the substrate 1, the insulating film 1d being comprised of an insulating material other than SiO₂. Further, a Si-substrate 1a in which Si-(100) or Si-(111), etc., is exposed on a surface thereof, namely, a Si-substrate not including the surface oxide film 1b or the insulating film 1d may also be used as the substrate 1. Further, an SOI (Silicon On Insulator) substrate, a quartz glass (SiO₂) substrate, a gallium arsenide (GaAs) substrate, a sapphire (Al₂O₃) substrate, a metal substrate comprised of a metal material such as stainless steel (SUS) may also be used as the substrate 1. The single-crystal Si-substrate 1a has a thickness of, for example, 300 to 1000 µm, and the surface oxide film 1b has a thickness of, for example, 1 to 4000 nm.

The bottom electrode film 2 can be comprised of, for example, platinum (Pt). The bottom electrode film 2 is a single crystal film or a polycrystalline film (these are also referred to as Pt-film hereafter). Preferably, crystals comprised in the Pt-film are preferentially oriented in (111) direction with respect to a surface of the substrate 1. Namely, a surface of the Pt-film (a surface which is a base of the piezoelectric film 3) is preferably mainly constituted of Pt-(111). The Pt-film can be formed (provided, deposited) using a method such as a sputtering method, or an evaporation method. Instead of Pt, the bottom electrode film 2 may also be comprised of various metals such as gold (Au), ruthenium (Ru), or iridium (Ir), an alloy mainly composed of the above various metals, or a metallic oxide such as strontium ruthenium oxide (SrRuO₃, abbreviated as SRO), or lanthanum nickel oxide (LaNiO₃, abbreviated as LNO), etc. An adhesion layer 6 mainly composed of, for example, titanium (Ti), tantalum (Ta), titanium oxide (TiO₂), nickel (Ni), ruthenium oxide (RuO₂), or iridium oxide (IrO₂), etc., may be formed between the substrate 1 and the bottom electrode film 2 in order to enhance an adhesion between them. The adhesion layer 6 can be formed using a method such as a sputtering method, or an evaporation method. The bottom electrode film 2 has a thickness of, for example, 100 to 400 nm, and the adhesion layer 6 has a thickness of, for example, 1 to 200 nm.

The piezoelectric film 3 is comprised of alkali niobium oxide which contains potassium (K), sodium (Na), and niobium (Nb), and which is represented by a composition formula of (K₁₋ₓNaₓ)NbO₃. Namely, the piezoelectric film 3 is comprised of potassium sodium niobium oxide (KNN). A coefficient x [= Na/(K+Na)] in the above composition formula is a value in a range of 0 < x < 1. The piezoelectric film 3 is a polycrystalline film of KNN (also referred to as KNN-film 3 hereafter). A crystal structure of KNN is a perovskite structure. The KNN-film 3 may contain a substance other than K, Na, and Nb. Here, a film containing K, Na, and Nb at a concentration of 90 % or more is the KNN-film 3. Examples of the substance other than K, Na, and Nb include: calcium zirconium oxide (CaZrO₃, abbreviated as CZO) or barium zirconium oxide (BaZrO₃, abbreviated as BZO). The KNN-film 3 can be formed using a method such as a sputtering method, a PLD (Pulsed Laser Deposition) method, or a sol-gel method. The KNN-film 3 has a thickness of, for example, 0.5 to 5 µm.

Preferably, crystals comprised in the KNN-film 3 are preferentially oriented in (001) direction with respect to the surface of the substrate 1 (the surface of the Si-substrate 1a when the substrate 1 is, for example, the Si-substrate 1a including the surface oxide film 1b or the insulating film 1d, etc.). Namely, a surface of the KNN-film 3 (a surface which is a base of the top electrode film 4) is preferably mainly constituted of KNN-(001 ). By forming the KNN-film 3 directly on the Pt-film preferentially oriented in (111) direction with respect to the surface of the substrate 1, crystals comprised in the KNN-film 3 can be easily preferentially oriented in (001) direction with respect to the surface of the substrate 1. For example, 80 % or more crystals in a crystal grain group comprised in the KNN-film 3 can be easily oriented in (001) direction with respect to the surface of the substrate 1, and 80 % or more regions of the surface of the KNN-film 3 can be easily KNN-(001).

More than half of the crystals in the crystal grain group comprised in the KNN-film 3 preferably have a columnar structure. Further, boundaries between the crystals comprised in the KNN-film 3, namely crystal grain boundaries existing in the KNN-film 3 preferably penetrate the KNN-film 3 in a thickness direction. For example, the number of the crystal grain boundaries penetrating the KNN-film 3 in the thickness direction is preferably larger than the number of the crystal grain boundaries not penetrating the KNN-film 3 in the thickness direction (for example, crystal grain boundaries in parallel to a planar direction of the substrate 1).

The KNN-film 3 comprises crystals, (each) having a grain size (also referred to as "KNN-crystal grain size" hereafter) with a standard deviation (also referred to as "standard deviation of the KNN-film 3" hereafter) of more than 0.42 µm, preferably 0.45 µm or more, more preferably 0.50 µm or more. An upper limit of the standard deviation of the KNN-film 3 is not particularly limited, but is usually about 0.6 µm according to a current technique.

The standard deviation of the KNN-film 3 can be increased by making an initial deposition rate slower than a latter deposition rate when forming the KNN-film 3. The standard deviation of the KNN-film 3 can be more than 0.42 µm, preferably 0.45 µm or more, because the initial deposition rate is, for example, less than 0.5 µm/h, preferably 0.2 µm/h or more and 0.5 µm/h or less, more preferably 0.2 µm/h or more and 0.4 µm/h or less, and the latter deposition rate is, for example, 0.5 µm/h or more and 2 µm/h or less, preferably 0.5 µm/h or more and 1.5 µm/h or less, more preferably 0.5 µm/h or more and 1 µm/h or less.

The initial deposition rate is a deposition rate in an initial stage of forming the KNN-film 3 (deposition). The initial stage of deposition is a nucleation stage of forming KNN-nuclei (KNN-crystal nuclei) on the bottom electrode film 2 (the base of the KNN-film 3). The initial deposition is performed in a period, for example, from start of forming the KNN-film 3 until 3 to 5 minutes. The latter deposition rate is a deposition rate in a latter stage of forming the KNN-film 3 (deposition). The latter stage of deposition is a stage after the initial stage of deposition, and is a nucleus growth stage of forming the KNN-film 3 by growing the nuclei formed in the initial stage of deposition.

The number of the nuclei generated on the bottom electrode film 2 can be decreased (a nuclear density can be lowered) by making the deposition rate (that is, the initial deposition rate) slow during a nucleation. As a result, in the initial stage of deposition, the nuclei are formed sparsely (in island-shaped) on the bottom electrode film 2.

By forming sparsely the nuclei in the initial stage of deposition, the size of the nuclei can be more non-uniform and the size of each crystal grain comprised in the KNN-film 3 can be more non-uniform than a case of forming densely the nuclei (forming the nuclei with a high nuclear density). As a result, the standard deviation of the KNN-film 3 can be increased.

Further, since the nuclei are sparsely formed in the initial stage of deposition, in the latter stage of deposition, the nuclei formed in the initial stage of deposition start to grow, and meanwhile, the nuclei are formed with a delay in a part on the bottom electrode film 2 where the nuclei are not formed. It takes shorter for the nuclei formed in the latter stage of deposition to grow, than the nuclei formed in the initial stage of deposition. Therefore, the crystal grains whose nuclei are formed in the latter stage of deposition and grow, become smaller than the crystal grains whose nuclei are formed in the initial stage of deposition and grow. Also, by forming the nuclei in the latter stage of deposition as described above, the standard deviation of the KNN-film 3 can be increased.

The nuclei formed in the latter stage of deposition grow so as to bridge the inter-nuclei gap of the nuclei which are formed in the initial stage of deposition and which have already started to grow. In the present embodiment, by forming sparsely the nuclei in the initial stage of deposition, the inter-nuclei gap of the adjacent nuclei is wider, than a case of forming densely the nuclei in the initial stage of deposition. Therefore, even when the KNN-film 3 grows until its thickness reaches a specific thickness, it is difficult to completely bridge the inter-nuclei gap of the nuclei which are formed in the initial stage of deposition and grow, by the nuclei which are formed in the latter stage of deposition and grow. As described above, since the standard deviation of the KNN-film 3 is large, gaps between the crystal grains comprised in the KNN-film 3 are large.

Since the gaps between the crystal grains comprised in the KNN-film 3 are large, a wet etching rate (also referred to as "WER" hereafter) of the KNN-film 3 for a prescribed etching solution (for example, an etching solution including an alkali aqueous solution of a chelating agent and not including hydrofluoric acid) can be increased. Namely, since the gaps between the crystal grains comprised in the KNN-film 3 are large, it is easy to advance an etching of the KNN-film 3 using a specific etching solution. For example, since the standard deviation of the KNN-film 3 is more than 0.42 µm, the etching rate of the KNN-film 3 can be 0.1 µm/min or more, preferably 0.2 µm/min or more, when the KNN-film 3 is immersed in the etching solution obtained by mixing ethylenediaminetetraacetic acid (abbreviated as EDTA, 5 g, and 0.01 mol/l or more and 0.1 mol/1 or less (0.01 M or more and 0.1 M or less) as the chelating agent, ammonia water (NH₂OH, 29 %, and 37 ml), and hydrogen peroxide water (30%, and 125 ml). Ethylenediaminetetraacetic acids (EDTAs), and diethylenetriaminepentaacetic acids (DTPAs) can be used as the chelating agent. At least one selected from ethylenediaminetetraacetic acid-disodium salt dihydrate (EDTA·2Na), ethylenediaminetetraacetic acid-trisodium salt trihydrate (EDTA·3Na), ethylenediaminetetraacetic acid-tetrasodium salt tetrahydrate (EDTA·4Na), ethylenediaminetetraacetic acid-dipotassium salt dihydrate (EDTA·2K), ethylenediaminetetraacetic acid-tripotassium salt dihydrate (EDTA·3K), and ethylenediaminetetraacetic acid-diammonium salt (EDTA·2NH₃)can be preferably used as a kind of EDTAs, in addition to EDTA.

The KNN-film 3 can comprise the crystals (crystal group) having an average grain size (also referred to as "average grain size of the KNN-film 3" hereafter) of, for example, more than 1.0 µm and 5 µm or less, preferably 1.5 µm or more and 4 µm or less. The average grain size of the KNN-film 3 used here is the average grain size in a cross-section of the KNN-film 3 in the planar direction of the substrate 1. The average grain size of the KNN-film 3 can be obtained by analyzing a visual field of an image (for example, SEM image) imaged using a scanning electron microscopy or an image (for example, TEM image) imaged using a transmission electron microscopy. For example, "Image J" manufactured by Wayne Rasband can be used as an image analysis software.

Since the average grain size of the KNN-film 3 is more than 1.0 µm, the KNN-film 3 having the standard deviation of more than 0.42 µm can be easily obtained. Since the average grain size of the KNN-film 3 is 1.5 µm or more, the KNN-film 3 having the standard deviation within the above range can be more easily obtained. When the average grain size of the KNN-film 3 is 1.0 µm or less, the KNN-film 3 having the standard deviation within the above range cannot be sometimes obtained, because the nuclei are required to be densely formed on the bottom electrode film 2.

Since the average grain size of the KNN-film 3 is 5 µm or less, a distribution of physical property values of the KNN-film 3 can be uniform in a plane, and since the average grain size of the KNN-film 3 is 4 µm or less, the distribution of the physical property values of the KNN-film 3 can be more uniform in the plane. Examples of "physical property values of the KNN-film 3" used here include: values of a piezoelectric constant of the KNN-film 3, values of a leakage current density, and values of a dielectric constant, etc.

The KNN-film 3 contains at least one of metallic elements selected from a group consisting of copper (Cu) and manganese (Mn) at a concentration within a range of 0.2 at% or more and 2.0 at% or less. When adding both Cu and Mn into the KNN-film 3, Cu and Mn are added into the KNN-film 3 so that a total concentration of Cu and Mn falls within the above concentration range.

Since at least one of Cu or Mn is added into the KNN-film 3 within the above concentration range, a film property of the KNN-film 3 can be improved. For example, an insulation property (a leak resistance) of the KNN-film 3 can be improved, and a dielectric constant of the KNN-film 3 can be a value suitable for applications of the piezoelectric stack 10.

For example, since the total concentration of Cu and Mn in the KNN-film 3 is within the above range, a leakage current density when applying an electric field of 250 kV/cm to the KNN-film 3 in a thickness direction can be 500 µA/cm² or less, preferably 250 µA/cm² or less, more preferably 200 µA/cm² or less.

Further, since the total concentration of Cu and Mn in the KNN-film 3 is within the above range, the dielectric constant of the KNN-film 3 can be 1500 or less, preferably 300 or more and 1200 or less when being measured under a condition of a frequency of 1 kHz and ± 1 V. When the piezoelectric stack 10 is utilized, for example, as a sensor, the above range of the dielectric constant of the KNN-film 3 is less likely to cause a decrease of a sensitivity. One reason can be considered as follows: an addition amount of Cu or Mn is appropriate, and the crystals comprised in the KNN-film 3 can be preferentially oriented in (001) direction with respect to the surface of the substrate 1.

Further, since Cu is added into the KNN-film 3 within the above concentration range, the KNN-film 3 can have a longer life. This is because oxygen vacancies (oxygen deficiencies) exist at a predetermined ratio inside the crystals (crystal grains) comprised in the KNN-film 3 or on the grain boundaries in the KNN-film 3. The oxygen vacancies on the grain boundaries in the KNN-film 3 sometimes move when, for example, applying an electric field to the KNN-film 3. When the oxygen vacancies move and spread over the electrode film (the bottom electrode film 2 or the top electrode film 4), the oxygen vacancies react with the metal comprised in the electrode film, resulting in causing short-circuit. Since Cu is added into the KNN-film 3 within the above concentration range, Cu makes a pair with the oxygen vacancies on the grain boundaries in the KNN-film 3, namely Cu on the grain boundaries traps the oxygen vacancies, and therefore the oxygen vacancies that exist on the grain boundaries in the KNN-film 3 and move to the electrode film when applying the electric field, etc., can be reduced. As a result, the KNN-film 3 can have a longer life.

Further, since Cu is added into the KNN-film 3 within the above concentration range, the WER for the etching solution including the alkali aqueous solution of the chelating agent can be within the above range, the above film property can be improved, and in addition, a resistance (etching resistance) to a fluorine-based etching solution (for example, buffered hydrofluoric acid (BHF) solution including hydrogen fluoride (HF) and ammonium fluoride (NH₄F), at a prescribed concentration respectively) can be improved. Thereby, a formation of a protection film for protecting an exposed surface of the KNN-film 3 is not required. Namely, the BHF solution can be used as the etching solution with no need to form the protection film. As a result, processes after forming the piezoelectric stack 10 can be simplified.

The KNN-film 3 may contain an element such as lithium (Li), Ta, antimony (Sb) other than K, Na, Nb, Cu, and Mn at a concentration where the standard deviation of the KNN-film 3 can be maintained within the above range, for example, at the concentration of 5 at% or less.

The top electrode film 4 can be comprised of various metals such as, for example, Pt, Au, aluminum (Al), or Cu, or an alloy of these various metals. The top electrode film 4 can be formed (provided, deposited) using a method such as a sputtering method, an evaporation method, a plating method, or a metal paste method. The top electrode film 4 does not greatly affect the crystal structure of the KNN-film 3 unlike the bottom electrode film 2. Therefore, a material and a crystal structure of the top electrode film 4, and a method of forming the top electrode film 4 are not particularly limited. An adhesion layer mainly composed of, for example, Ti, Ta, TiO₂, Ni, etc., may be formed between the KNN-film 3 and the top electrode film 4 in order to enhance an adhesion between them. The top electrode film 4 has a thickness of, for example, 10 to 5000 nm, and the adhesion layer has a thickness of, for example, 1 to 200 nm when forming the adhesion layer.

### (2) A constitution of a piezoelectric device

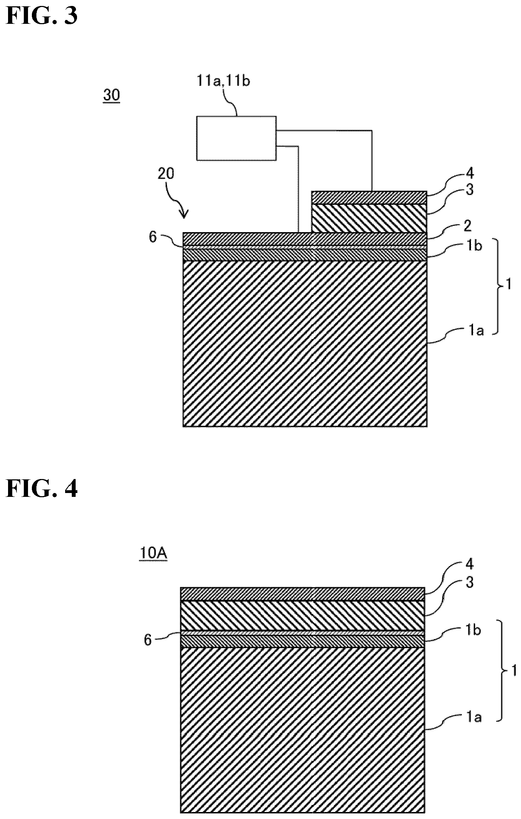

FIG. 3 illustrates a schematic constitution view of a device 30 (also referred to as piezoelectric device 30 hereafter) including the KNN-film 3 according to the present embodiment. The piezoelectric device 30 includes at least an element 20 (an element 20 including the KNN-film 3, and also referred to as piezoelectric element 20 hereafter) obtained by forming the above piezoelectric stack 10 into a prescribed shape, and a voltage application unit 11a or a voltage detection unit 11b connected to the piezoelectric element 20. The voltage application unit 11a is a means for applying a voltage between the bottom electrode film 2 and the top electrode film 4 (between electrodes), and the voltage detection unit 11b is a means for detecting a voltage generated between the bottom electrode film 2 and the top electrode film 4 (between electrodes). Publicly-known various means can be used as the voltage application unit 11a and the voltage detection unit 11b.

By connecting the voltage application unit 11a between the bottom electrode film 2 and the top electrode film 4 of the piezoelectric element 20, the piezoelectric device 30 can function as an actuator. By applying a voltage between the bottom electrode film 2 and the top electrode film 4 using the voltage application unit 11a, the KNN-film 3 can be deformed. Various structures connected to the piezoelectric device 30 can be actuated due to the above deformation motion. In this case, the piezoelectric device 30 can be applied to, for example, a head for an inkjet printer, a MEMS mirror for a scanner, and a vibrator for an ultrasonic generator, etc.

By connecting the voltage detection unit 11b between the bottom electrode film 2 and the top electrode film 4 of the piezoelectric element 20, the piezoelectric device 30 can function as a sensor. When the KNN-film 3 is deformed according to a variation of some physical quantity, a voltage is generated between the bottom electrode film 2 and the top electrode film 4 due to the deformation. By detecting this voltage using the voltage detection unit 11b, the physical quantity applied to the KNN-film 3 can be measured. In this case, the piezoelectric device 30 can be applied to, for example, an angular velocity sensor, an ultrasonic sensor, a pressure sensor, and an acceleration sensor, etc.

(3) A method of manufacturing a piezoelectric stack, a piezoelectric element, and a piezoelectric device (according to the invention in as far as it results in a piezoelectric stack according to present claim 1 or a piezoelectric element or device according to claim 4). A method of manufacturing the above piezoelectric stack 10, the piezoelectric element 20, and the piezoelectric device 30 will be described hereafter.

First, the substrate 1 is prepared, and the adhesion layer 6 (Ti-layer) and the bottom electrode film 2 (Pt-film) are formed in this order on any one of main surfaces of the substrate 1 using, for example, the sputtering method. It is also acceptable to prepare the substrate 1 on which the adhesion layer 6 and the bottom electrode film 2 are formed in advance on any one of its main surfaces.

For example, the following conditions are given as the conditions for forming the adhesion layer 6.
Temperature (substrate temperature): 100 ° C or more and 500 °C or less, preferably 200 °C or more and 400 ° C or less
RF power: 1000 W or more and 1500 W or less, preferably 1100 W or more and 1300 W or less
Atmosphere: Argon (Ar) gas atmosphere
Atmosphere pressure: 0.1 Pa or more and 0.5 Pa or less, preferably 0.2 Pa or more and 0.4 Pa or less
Time: 30 seconds or more and 3 minutes or less, preferably 30 seconds or more and 2 minutes or less

For example, the following conditions are given as the conditions for forming the bottom electrode film 2.
Deposition temperature (substrate temperature): 100 °C or more and 500 °C or less, preferably 200 °C or more and 400 ° C or less
RF power: 1000 W or more and 1500 W or less, preferably 1100 W or more and 1300 W or less
Deposition atmosphere: Ar-gas atmosphere
Atmosphere pressure: 0.1 Pa or more and 0.5 Pa or less, preferably 0.2 Pa or more and 0.4 Pa or less
Deposition time: 3 minutes or more and 10 minutes or less, preferably 4 minutes or more and 7 minutes or less

Next, the KNN-film 3 is formed on the bottom electrode film 2 using, for example, the sputtering method. A composition ratio of the KNN-film 3 can be adjusted by controlling, for example, a composition of a target material used during sputtering. The target material can be produced by mixing and baking K₂CO₃-powder, Na₂CO₃-powder, Nb₂O₅-powder, Cu-powder (or CuO-powder, Cu₂O-powder), and MnO-powder, etc. The composition of the target material can be controlled by adjusting a mixed ratio of K₂CO₃-powder, Na₂CO₃-powder, Nb₂O₅-powder, Cu-powder (or CuO-powder, Cu₂O-powder), and MnO-powder.

For example, the following conditions are given as the conditions for forming the KNN-film 3. A deposition time is appropriately set in accordance with the thickness of the KNN-film 3 to be formed.
Deposition temperature (substrate temperature): 500 °C or more and 700 °C or less, preferably 550 °C or more and 650 ° C or less
RF power: 2000 W or more and 2400 W or less, preferably 2100 W or more and 2300 W or less
Deposition atmosphere: Ar-gas + oxygen (O₂) gas atmosphere
Atmosphere pressure: 0.2 Pa or more and 0.5 Pa or less, preferably 0.2 Pa or more and 0.4 Pa or less
Partial pressure of Ar-gas to O₂-gas (partial pressure ratio of Ar/O₂): 30/1 to 20/1, preferably 27/1 to 23/1
Initial deposition period: a period from the start of deposition (0 minute) until 5 minutes, preferably a period from the start of deposition until 3 minutes
Latter deposition period: a period after the initial deposition period
Initial deposition rate: less than 0.5 µm/h, preferably 0.2 µm/h or more and less than 0.5 µm/h, more preferably 0.2 µm/h or more and 0.4 µm/h or less Latter deposition rate: 0.5 µm/h or more and 2 µm/h or less, preferably 0.5 µm/h or more and 1.5 µm/h or less, more preferably 0.5 µm/h or more and 1 µm/h or less

Then, the top electrode film 4 is formed on the KNN-film 3 using, for example, the sputtering method. Conditions for forming the top electrode film 4 may be the same conditions for forming the bottom electrode film 2 as described above. Thereby, the piezoelectric stack 10 including the substrate 1, the bottom electrode film 2, the KNN-film 3, and the top electrode film 4 can be obtained as illustrated in FIG. 1.

Then, by forming this piezoelectric stack 10 into a prescribed shape using etching, etc., the piezoelectric element 20 is obtained as illustrated in FIG. 3, and by connecting the voltage application unit 11a or the voltage detection unit 11b to the piezoelectric element 20, the piezoelectric device 30 is obtained.

### (4) Effect obtained by the present embodiment

According to the present embodiment, one or more of the following effects can be obtained.
(a) Since the standard deviation of the KNN-film 3 is large, namely, since the standard deviation of the KNN-film 3 is more than 0.42 µm, the WER (for example, the WER to the etching solution including the alkali aqueous solution of the chelating agent and not including hydrofluoric acid) of the KNN-film 3 can be increased without adversely affecting the physical property of the KNN-film 3. For example, the following merit can be obtained, because the above WER of the KNN-film 3 is increased.

For example, explanations will be given for a process after forming the piezoelectric stack 10 by forming the adhesion layer 6, the bottom electrode film 2, the KNN-film 3, and the top electrode film 4 in this order on the substrate 1. In a process of forming the piezoelectric element 20 or the piezoelectric device 30, when the piezoelectric stack 10 is formed into a prescribed shape, a process of forming the KNN-film 3 into a prescribed shape, is sometimes performed by wet etching using the etching solution including the alkali aqueous solution of the chelating agent, etc. Since the WER of the KNN-film 3 can be increased as described above, an efficiency of the above etching treatment of the KNN-film 3 can be improved. As a result, a productivity of the piezoelectric element 20 or the piezoelectric device 30 can be improved.

Further, the time required for immersing the KNN-film 3 (piezoelectric stack 10) in the etching solution can also be shortened. As a result, an etching damage of the KNN-film 3 caused by etching can also be suppressed. Namely, it is possible to minimize an impact of the etching on the physical property of the KNN-film 3.

(b) Since at least one of Cu or Mn is added into the KNN-film 3 within the above concentration range, the film property of the KNN-film 3 can be improved while maintaining the high WER of the KNN-film 3. Further, since Cu is added into the KNN-film 3 within the above concentration range, the movement of the oxygen vacancies on the grain boundaries in the KNN-film 3 can be suppressed. As a result, the KNN-film 3 can have a longer life.

(c) Since the average grain size of the KNN-film 3 is more than 1.0 µm and 5 µm or less, the KNN-film 3 can have the uniform distribution of the physical property values in the plane while having the standard deviation within the above range. Since the distribution of the physical property values of the KNN-film 3 is uniform in the plane, a deterioration of the KNN-film 3 (for example, a decrease of the piezoelectric constant, etc.) can be suppressed when driving the KNN-film 3 by applying the electric field to the piezoelectric element 20 or the piezoelectric device 30 produced by processing the piezoelectric stack 10.

### <Other embodiments>

As described above, explanations have been given specifically for the embodiment of the present invention. However, the present invention is not limited to the above embodiment or the above modified examples, and can be variously modified within the scope of the claims.
(a) For example, the piezoelectric stack 10 may not include the bottom electrode film 2. The piezoelectric stack 10 may be constituted including the substrate 1, the KNN-film (piezoelectric film) 3 formed on the substrate 1, and the top electrode film 4 (electrode film 4) formed on the KNN-film 3. Also in this case, since the standard deviation of the KNN-film 3 is more than 0.42 µm, the WER of the KNN-film 3 can be increased as described above.

FIG. 4 illustrates a cross-section constitution view of the piezoelectric stack 10A not including the bottom electrode film 2. The piezoelectric stack 10A can be obtained by forming the adhesion layer 6 on the substrate 1, forming the KNN-film 3 on the adhesion layer 6, and forming the electrode film 4 on the KNN-film 3. Conditions for forming (deposition) each film (layer) included in the piezoelectric stack 10A may be the same conditions for forming each film (layer) included in the piezoelectric stack 10 as described in the above embodiment. Also in the piezoelectric stack 10A, the standard deviation of the KNN-film 3 can be within the above range by making the initial deposition rate slower than the latter deposition rate. The piezoelectric stack 10A may not include the adhesion layer 6. Namely, the KNN-film 3 may be formed directly on the substrate 1.

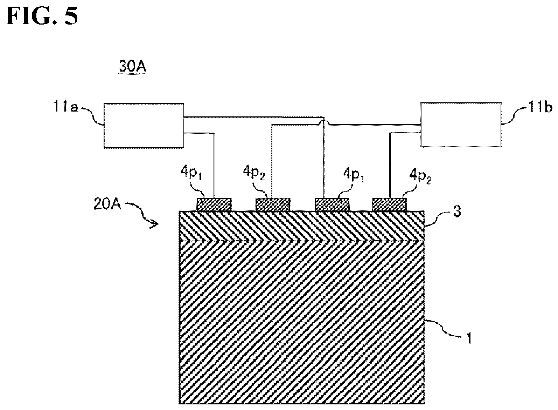

FIG. 5 illustrates the schematic constitution view of a piezoelectric device 30A produced using the piezoelectric stack 10A. The piezoelectric device 30A is constituted including at least a piezoelectric element 20A obtained by forming the piezoelectric stack 10A into a prescribed shape, and the voltage application unit 11a and the voltage detection unit 11b connected to the piezoelectric element 20A. In the present embodiment, the piezoelectric element 20A has a pattern electrode obtained by forming the electrode film 4 into a prescribed pattern. For example, the piezoelectric element 20A has a pair of positive and negative pattern electrodes 4p₁ which are input-side electrodes, and a pair of positive and negative pattern electrodes 4p₂ which are output-side electrodes. For example, a comb-shaped electrode (Inter Digital Transducer, abbreviated as IDT) is used as the pattern electrodes 4p₁ and 4p₂.

By connecting the voltage application unit 11a between the pattern electrodes 4p₁ and connecting the voltage detection unit 11b between the pattern electrodes 4p₂, the piezoelectric device 30A can function as a filter device such as a Surface Acoustic Wave (abbreviated as SAW) filter. By applying the voltage between the pattern electrodes 4p₁ using the voltage application unit 11a, a SAW can be excited on the surface of the KNN-film 3. A frequency of the excited SAW can be adjusted by adjusting, for example, a pitch between the pattern electrodes 4p₁. For example, the shorter the pitch of IDT as the pattern electrodes 4p₁, the higher the frequency of the SAW, and the longer the above pitch, the lower the frequency of the SAW. The voltage is generated between the pattern electrodes 4p₂, due to a SAW having a prescribed frequency (frequency component) determined according to the pitch of IDT as the pattern electrodes 4p₂ in the SAW which is excited by the voltage application unit 11a, propagates in the KNN-film 3, and reaches the pattern electrodes 4p₂. By detecting this voltage using the voltage detection unit 11b, a

SAW having a prescribed frequency in the excited SAW can be extracted. The "prescribed frequency" as used here can include not only a prescribed frequency but also a prescribed frequency band whose center frequency is the prescribed frequency.

(b) For example, an orientation control layer may be formed (provided, deposited) for controlling orientations of the crystals comprised in the KNN-film 3 between the bottom electrode film 2 and the KNN-film 3, namely, directly under the KNN-film 3. In a case of not forming the bottom electrode film 2, the orientation control layer may be formed between the substrate 1 and the KNN-film 3. The orientation control layer can be comprised of a material which is a metallic oxide such as SRO, LNO, or strontium titanium oxide (SrTiO₃, abbreviated as STO), and which is different from the material comprised of the bottom electrode film 2. Preferably, crystals comprised in the orientation control layer are preferentially oriented in (100) direction with respect to the surface of the substrate 1.

(c) For example, in addition to Cu or Mn, the KNN-film 3 may contain other metallic elements obtaining an effect equivalent to Cu or Mn at a concentration where the above effect on the insulation property, the above effect on the dielectric constant, or the above effect of suppressing the movement of the oxygen vacancies, can be obtained while maintaining the high WER of the KNN-film 3. Also in this case, the same effects as the above embodiment, etc., can be obtained.

(d) For example, the substrate 1 may be removed from the piezoelectric stack 10, 10A when forming the above piezoelectric stack 10, 10A into the piezoelectric element 20, 20A, as long as the piezoelectric device 30, 30A produced using the piezoelectric stack 10, 10A (piezoelectric element 20, 20A) is applied to desired applications such as a sensor or an actuator.

In the piezoelectric stack of the present invention, it is preferred that the piezoelectric film comprises crystals having a grain size with a standard deviation of 0.45 µm or more. Furthermore, it is preferred that the metallic element is Cu. The piezoelectric film of the piezoelectric stack preferably comprises the crystals having an average grain size of 1.5 µm or more and 4 µm or less.

The following methods are according to the invention in as far as they relate to the preparation of the piezoelectric stack according to the claims. The first method is a method of manufacturing a piezoelectric stack, including:
forming an electrode film on a substrate; and
forming a piezoelectric film on the electrode film, the piezoelectric film being comprised of alkali niobium oxide of a perovskite structure represented by a composition formula of (K₁₋ₓNaₓ)NbO₃ (0 < x < 1),
wherein in the formation of the piezoelectric film, an initial deposition rate is slower than a latter deposition rate.

The second method is a method of manufacturing a piezoelectric stack, including:
forming a piezoelectric film on a substrate, the piezoelectric film being comprised of alkali niobium oxide of a perovskite structure represented by a composition formula of (K₁₋ₓNaₓ)NbO₃ (0 < x < 1),
wherein in the formation of the piezoelectric film, an initial deposition rate is slower than a latter deposition rate.

Preferably, in the aforementioned first method and/or second method, the initial deposition rate is less than 0.5 µm/h and the latter deposition rate is 0.5 µm/h or more and 2 µm/h or less.

### DESCRIPTION OF SIGNS AND NUMERALS

1 Substrate
2, 4 Electrode film
3 Piezoelectric film
   10, 10A Piezoelectric stack
20, 20A Piezoelectric element
30, 30A Piezoelectric device

## Claims

1. A piezoelectric stack (10, 10A), comprising:
a substrate (1);
an electrode film (2, 4); and
a piezoelectric film (3) which is comprised of alkali niobium oxide of a perovskite structure represented by a composition formula of (K₁₋ₓNaₓ)NbO₃ with 0 < x < 1,
**characterized in that** the piezoelectric film (3) comprises crystals having a grain size with a standard deviation of more than 0.42 µm, and
**in that** the piezoelectric film (3) contains a metallic element selected from a group consisting of Cu and Mn at a concentration of 0.2 at% or more and 2.0 at% or less.

2. The piezoelectric stack (10, 10A) according to claim 1, wherein the piezoelectric film (3) has an etching rate of 0.1 µm/min or more, when etching using an etching solution obtained by mixing ethylenediaminetetraacetic acid as a chelating agent of 5 g and 0.1 M or less, 37 ml of ammonia water with an ammonia concentration of 29%, and 125 ml of hydrogen peroxide water with a concentration of 30%.

3. The piezoelectric stack (10, 10A) according to claim 1 or 2, wherein the piezoelectric film (3) comprises crystals having an average grain size of more than 1.0 µm and 5 µm or less.

4. A piezoelectric element (20, 20A) or piezoelectric device (30, 30A), comprising the piezoelectric stack (10, 10A) according to claim 1, wherein
(a) a bottom electrode film (2) is formed on the substrate (1);
the piezoelectric film (3) is formed on the bottom electrode film (2); and
a top electrode film (4) is formed on the piezoelectric film (3), or
(b) the piezoelectric film (3) is formed on the substrate (1) and the electrode film (4) is formed on the piezoelectric film (3).

## Patentansprüche

1. Ein piezoelektrischer Stapel (10, 10A), umfassend:
ein Substrat (1);
einen Elektrodenfilm (2, 4); und
einen piezoelektrischen Film (3), umfassend ein Alkali-Nioboxid mit einer Perowskit-Struktur, die durch eine Zusammensetzungsformel (K₁₋ₓNaₓ)NbO₃ dargestellt ist, wobei 0 < x < 1 ist,
**dadurch gekennzeichnet, dass** der piezoelektrische Film (3) Kristalle mit einer Korngröße mit einer Standardabweichung von mehr als 0,42 µm umfasst, und
dass der piezoelektrische Film (3) ein metallisches Element, ausgewählt aus einer Gruppe bestehend aus Cu und Mn, in einer Konzentration von 0,2 Atom-% oder mehr und 2,0 Atom-% oder weniger enthält.

2. Der piezoelektrische Stapel (10, 10A) nach Anspruch 1, wobei der piezoelektrische Film (3) eine Ätzrate von 0,1 µm/min oder mehr aufweist, wenn Ätzen unter Verwendung einer Ätzlösung, erhalten durch Mischen von 5 g und 0,1 M oder weniger Ethylendiamintetraessigsäure als Chelatbildner, 37 ml Ammoniakwasser mit einer Ammoniakkonzentration von 29% und 125 ml Wasserstoffperoxidwasser mit einer Konzentration von 30%, durchgeführt wird.

3. Der piezoelektrische Stapel (10, 10A) nach Anspruch 1 oder 2, wobei der piezoelektrische Film (3) Kristalle umfasst, die eine mittlere Korngröße von mehr als 1,0 µm und 5 µm oder weniger aufweisen.

4. Ein piezoelektrisches Element (20, 20A) oder eine piezoelektrische Vorrichtung (30, 30A), umfassend den piezoelektrischen Stapel (10, 10A) nach Anspruch 1, wobei
(a) ein unterer Elektrodenfilm (2) auf dem Substrat (1) ausgebildet ist;
der piezoelektrische Film (3) auf dem unteren Elektrodenfilm (2) ausgebildet ist; und
ein oberer Elektrodenfilm (4) auf dem piezoelektrischen Film (3) ausgebildet ist, oder
(b) der piezoelektrische Film (3) auf dem Substrat (1) ausgebildet ist und der Elektrodenfilm (4) auf dem piezoelektrischen Film (3) ausgebildet ist.

## Revendications

1. Empilement piézoélectrique (10, 10A) comprenant :
un substrat (1) ;
un film d'électrode (2, 4) ; et
un film piézoélectrique (3) comprenant de l'oxyde de niobium et du métal alcalin ayant une structure de perovskite et représenté par la formule de composition (K₁₋ₓNaₓ)NbO₃ où 0 < x < 1,
**caractérisé en ce que** le film piézoélectrique (3) comprend des cristaux ayant une grosseur de grain avec un écart type supérieur à 0,42 µm, et
**en ce que** le film piézoélectrique (3) contient un élément métallique choisi dans le groupe constitué par Cu et Mn à une concentration de 0,2 % atomique ou plus et 2,0 % atomiques ou moins.

2. Empilement piézoélectrique (10, 10A) selon la revendication 1, dans lequel le film piézoélectrique (3) a une vitesse de gravure de 0,1 µm/min ou plus, lors d'une gravure utilisant une solution de gravure obtenue par mélange de 5 g et 0,1 M d'acide éthylènediaminetétraacétique ou moins servant d'agent chélatant, 37 ml d'ammoniaque à une concentration d'ammoniac de 29 %, et 125 ml d'eau oxygénée à une concentration de 30 %.

3. Empilement piézoélectrique (10, 10A) selon la revendication 1 ou 2, dans lequel le film piézoélectrique (3) comprend des cristaux ayant une grosseur de grain moyenne supérieure à 1,0 µm et de 5 µm ou moins.

4. Elément piézoélectrique (20, 20A) ou dispositif piézoélectrique (30, 30A) comprenant l'empilement piézoélectrique (10, 10A) selon la revendication 1, dans lequel
(a) un film d'électrode inférieur (2) est formé sur le substrat (1) ;
le film piézoélectrique (3) est formé sur le film d'électrode inférieure (2) ; et
un film d'électrode supérieur (4) est formé sur le film piézoélectrique (3), ou
(b) le film piézoélectrique (3) est formé sur le substrat (1) et le film d'électrode (4) est formé sur le film piézoélectrique (3).
